# EUROPEAN PATENT SPECIFICATION

(11) **EP 2 629 431 B1**
(45) Date of publication and mention of the grant of the patent: **25.10.2017**
(21) Application number: 12155656.7
(22) Date of filing: 15.02.2012
(51) Int. Cl.: H04L 27/36, H04B 1/04, H03F 1/32, H03F 3/195, H03F 3/24

(54) **Method and apparatus to use auxiliary receiver to compensate IQ imbalance in multiple transmitters based upon one of the transmitters**
Verfahren und Vorrichtung zur Verwendung eines Hilfsempfängers zur Kompensation des IQ Ungleichgewichts mehrerer Sender auf Grundlage eines der Sender
Procédé et appareil pour utiliser un récepteur auxiliaire pour compenser IQ déséquilibre des plusieurs transmetteurs d'après l'un des transmetteurs

(43) Date of publication of application: 21.08.2013
(73) Proprietor: BlackBerry Limited, Waterloo, ON N2K 0A7 (CA)
(72) Inventor: Muhammad, Khurram, Garland, TX Texas 75044 (US); Kravets, Oleksiy, Waterloo, Ontario N2L 3W8 (CA)
(74) Representative: Roberts, Gwilym Vaughan

(56) References cited:
- US-A1- 2010 111 221
- US-A1- 2011 150 130
- US-B1- 7 856 048

## Description

### Technical Field

The present disclosure relates to the field of communications devices, and more particularly, communications devices with components that correct initial IQ imbalances.

### Background

In general, undesired or non-ideal characteristics, such as DC offset and in-phase/ quadrature-phase (IQ) imbalance, degrade performance of mobile transceivers. The DC offset is the effect of self mixing by a mixer, and occurs when a signal of a local oscillator (LO) returns after leaking toward an antenna or when a radio frequency (RF) modulation signal input through the antenna is leaked to the local oscillator. Another way to create DC offset is through an inherent offset in the amplifiers due to imbalances. If the DC offset is amplified by amplifiers in the signal path, then this way may saturate a baseband circuit.

The IQ imbalance is caused when the phase difference between the in-phase (I) channel signal and the quadrature-phase (Q) channel signal generated in an oscillator of a wireless transmitter is not 90 degrees. The IQ imbalance can be reduced by designing mixers of the I channel demodulator and the Q channel demodulator to be precisely 90 degrees in phase delay (i.e., orthogonal) to each other. However, designing the mixers so that there is precisely a 90 degrees phase difference to each other is not practical over process and temperature variations. This is because in the layout, the I and Q paths to the mixers traverse different lengths despite the best effort of keeping everything symmetrical. This is especially true for multi-band systems. An IQ imbalance increases the Bit Error Rate (BER), thereby degrading the performance of the wireless transceiver.

However, there is still a need to improve such compensation, and a need to reduce IQ imbalances and the associated distortion in mobile transmitters.

United States Patent Publication No. 2003/0150130 is directed to an active antenna array that comprises a plurality of transmission paths, a predistortion modulation signal generator, and a predistortion modulation signal distribution structure.

United States Patent Publication No. 7,856,048 is directed to methods and systems for autocalibrating a transceiver.

Aspects of an invention are defined in the appended independent claims. Some optional features are defined in the dependent claims

### Brief Description of the Drawings

FIG. 1 is a schematic block diagram of a first embodiment of a communications device the present disclosure.
FIG. 2 is a schematic block diagram of a second embodiment of a communications device of the present disclosure.
Fig. 3 is a schematic block diagram illustrating components of a mobile wireless communications device in accordance with an example embodiment of the present disclosure.

### Detailed Description

The present description is made with reference to the accompanying drawings, in which various embodiments are shown. However, many different embodiments may be used, and thus the description should not be construed as limited to the embodiments set forth herein. Rather, these embodiments are provided so that this disclosure will be thorough and complete. Like numbers refer to like elements throughout, and prime notation is used to indicate similar elements or steps in alternative embodiments.

Generally speaking, a communications device may include a plurality of wireless transmitters operable at different respective frequencies and each configured to generate respective IQ signals having an initial IQ imbalance. An auxiliary receiver may be coupled to a given wireless transmitter. A controller may be configured to apply predistortion to the each wireless transmitter of the plurality thereof based upon the initial IQ imbalance generated by the given wireless transmitter to reduce the initial IQ imbalance in each wireless transmitter.

Each wireless transmitter may comprise a digital signal processing (DSP) block configured to receive an input baseband signal and to generate the IQ signal having the IQ imbalance, and the controller may be configured to apply predistortion by generating and applying a predistortion signal to the DSP block. In addition, each wireless transmitter may further comprise at least one digital to analog converter (DAC) coupled downstream of the DSP block.

At least one mixer may be coupled downstream of the at least one DAC. A phase locked loop (PLL) may be coupled to the at least one mixer. At least one power amplifier may be downstream from the at least one mixer.

The auxiliary receiver may have a low noise amplifier (LNA), and at least one mixer coupled downstream of the LNA. A receiver phase locked loop (RXPLL) may be coupled to the at least one mixer. At least one analog to digital converter (ADC) may be coupled downstream of the at least one mixer, and a receiver DSP block may be coupled to the at least one ADC.

A method aspect is directed to a method of operating a communications device comprising a plurality of wireless transmitters operable at different respective frequencies and each configured to generate respective IQ signals having an initial IQ imbalance, an auxiliary receiver coupled to a given wireless transmitter, and a controller. The method may include applying predistortion to the each wireless transmitter of the plurality thereof based upon the initial IQ imbalance generated by the given wireless transmitter to reduce the initial IQ imbalance in each wireless transmitter, using the controller.

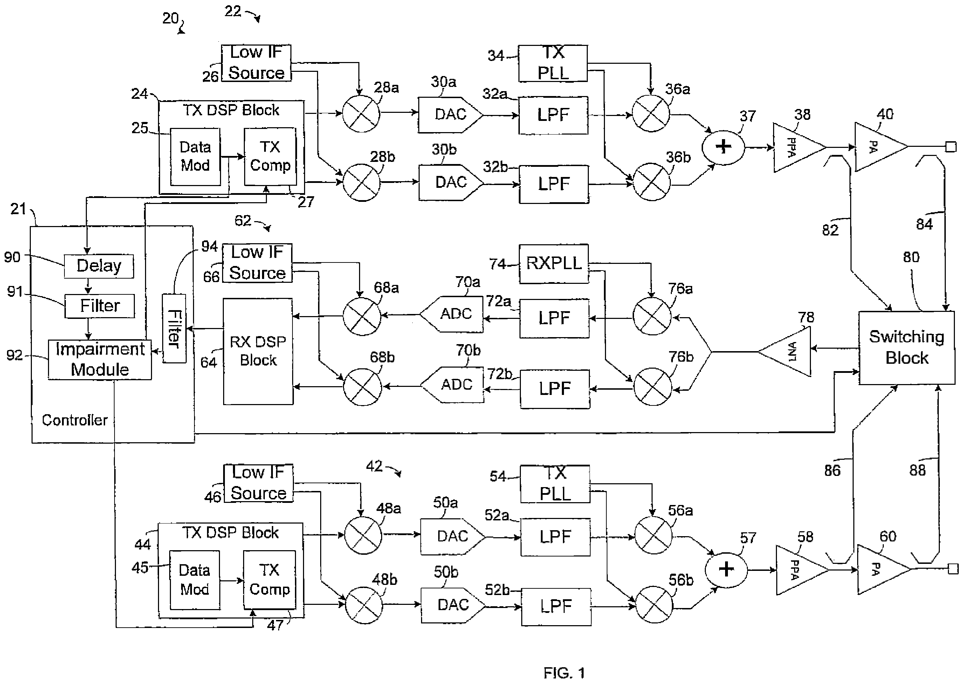

With reference to FIG. 1, a communications device **20** is now described. The communications device **20** may be a mobile wireless communications device, such as a smartphone. The communications device **20** may be a multifrequency band device that operates over a 2.4 GHz frequency band (i.e., approximately 2.4 to 2.483 GHz) and over a 5 GHz frequency band (i.e., approximately 4.9 to 6 GHz), for example. Depending on the intended application, the communications device **20** may operate over other frequency bands, as readily appreciated by those skilled in the art.

The communications device **20** includes a plurality of transmitters **22, 42,** and a tunable auxiliary receiver **62.** The communications device may include a housing commonly carrying the transmitters **22, 42** and the tunable auxiliary receiver. As will be explained in detail below, a controller **21** uses the tunable auxiliary receiver **62** to detect impairments such as initial IQ imbalances in signals output by the transmitters **22, 42** and directs the digital signal processing (DSP) blocks **24, 44** of the transmitters to correct input baseband signals so as to reduce the IQ imbalance in the signals output by the transmitters. The tunable auxiliary receiver **62** is coupled to one of the transmitters **24, 44** at a time by the switching block **80,** and is tunable to receive different frequencies so as to be able to service different transmitters operating at different frequencies.

The transmitter **22** will now be described in details. The transmitter **22** includes a transmit (TX) DSP block **24** configured to output baseband signal having in-phase (I) and quadrature (Q) components and to therefore generate and output complex IQ signals. The complex IQ signals have an IQ imbalance caused by other components of the transmitter **22,** meaning that there may be a phase imbalance between the I and Q signals (e.g. I and Q are not 90° apart in phase). The TX DSP block **24** comprises a data modulator **25** that generates the baseband signal, and a transmit compensator (TX compensator) **27** coupled thereto. As will be explained below, the controller **21** corrects the initial IQ imbalance using the TX compensator **27.**

The I and Q outputs from the TX DSP block **24** are mixed by the mixers **28a, 28b** to a low intermediate frequency (IF) by a low IF source **26** coupled to the mixers. Digital to analog converters (DACs) **30a, 30b** are coupled to the mixers **28a, 28b,** and low pass filters 32a, **32b** are coupled to the DACs.

Mixers **36a, 36b** are coupled to the low pass filters **32a, 32b.** The complex IQ signals are driven to the desired transmit frequency by the transmitter phase locked loop **34,** which is coupled to the mixers **36a, 36b.** The complex IQ signals (now at the desired transmit frequency) are summed by the summer **37,** and then fed downstream to a pre-power amplifier **38,** and in turn to a power amplifier **40.** The power amplifier **40** outputs a RF modulated signal having the initial IQ imbalance. The pre-power amplifier **38** is used to ensure that there is enough power to drive the power amplifier **40.**

The transmitter **42** contains similar components to the transmitter **22** and needs no further discussion herein, although it should be understood that the transmitter **42** may operate in a different frequency band than the transmitter **22.** In addition, it should be understood that the communications device **20** may include any numbers of transmitters, and that they make be similar to the transmitters **22, 42,** or may be different kinds of transmitters. The transmitters **22, 42** are each coupled to the switching block **80,** which is in turn coupled to the frequency tunable auxiliary receiver **62.**

An RF modulated signal having the initial IQ imbalance from a transmitter **22, 42** is provided to the frequency tunable auxiliary receiver **62** using a non-directional coupler **82, 86** coupled between the pre-power amplifier **38, 58** and the power amplifier **40, 60.** Alternatively, a non-directional coupler **84, 88** may be coupled between the power amplifier **40, 60** and the antenna (not shown).

An advantage of using a non-directional coupler **82, 86** is that it can operate over a wide band of operation, and its performance remains well controlled over temperature and frequency changes. In addition, a non-directional coupler **82, 86** helps to prevent the PLL **74** of the frequency tunable auxiliary receiver **62** from parasitically coupling to the output of the transmitter **16.** Instead of using a non-directional coupler, it is possible to use a directional coupler. The use of a directional coupler provides a steady feedback signal independent of the VSWR variation at the antenna or the PPA load. However, a non-directional coupler is preferred because it is wideband and simpler to implement.

The switching block **80** couples one of the transmitters **22, 42** at a time to the frequency tunable auxiliary receiver **62** via the couplers **82, 86, 84, 88.** The frequency tunable auxiliary receiver **62** is used to service the needs of the transmitters **22, 42.** Estimation and compensation for IQ imbalance and DC offset are examples of servicing the needs of the transmitters **22, 42,** as will be appreciated by those skilled in the art.

The frequency tunable auxiliary receiver **62** can be of lower performance as compared to a main receiver (not shown) of the communications device **20** since it is primarily designed to serve the transmitters **22, 42.** For example, the frequency tunable auxiliary receiver **62** may not need to have a high dynamic range like a main receiver, nor a high selectivity.

The frequency tunable auxiliary receiver **62** is configured to have an independent, dedicated phase-locked loop **74** that is offset from the TX PLL **34, 54** operating the transmitters **22, 42.** This advantageously allows the initial IQ imbalance, to be separated in the frequency domain from IQ imbalances or other impairments added in the frequency tunable auxiliary receiver **62.**

As explained above, the auxiliary receiver **62** includes a low noise amplifier **78** to receive the RF modulated signal having the IQ imbalance. The output of the low noise amplifier **78** is provided to the mixers **76a, 76b.** The frequency tunable auxiliary receiver **62** is configured as a 0-IF receiver since the transmitters **22, 42** are is configured as low-IF transmitters (i.e., dual-mixer mode). This means that a second set of mixers **68a, 68b** may not be needed and is selectively set to a value of 1 (i.e., e^{j0}) by the low IF source **66.** In a different embodiment, the switching block **80** can be combined with the LNA **78** to provide two input pairs, one of which is selected under software control.

The mixers **76a, 76b** receive the RF modulated signal having the IQ imbalance, and I and Q local oscillator signals from the RX PLL **74.** As noted above, the frequency tunable auxiliary receiver **62** is configured to have an independent, dedicated phase-locked loop **74** that is offset from the PLL's **34, 54** of the transmitters **22, 42.** This advantageously allows the initial IQ imbalance in the RF modulated signal to be separated in the frequency domain from impairments added in the frequency tunable auxiliary receiver **62.**

The output of the mixers **76a**, **76b** provide receive modulated analog I and Q component signals at the intermediate frequency. These signals are provided to low pass filters **72a, 72b** and then to analog-to-digital converters **70a, 70b** so that the receive baseband modulated analog I and Q component signals are now receive baseband modulated digital I and Q component signals at the intermediate frequency. The receive baseband modulated digital I and Q component signals at the intermediate frequency include the receive impairment (initial IQ imbalance) spectrally separated from the transmit impairment. These signals are passed through the mixers **68a, 68b,** which translate this complex signal to zero-IF in a second down-conversion operation by frequency using the low IF source **46.**

The controller **21** is coupled to the output of the data modulator **25, 45** and to the output of the frequency tunable auxiliary receiver **62.** The controller **21** receives the transmit baseband modulated signal from the data modulator **25, 45.** The transmit baseband modulated signal is also referred to as the reference signal since it does not include the initial IQ imbalance from the transmitters **22, 42.**

The controller **21** also receives the receive baseband modulated signal as provided by the auxiliary receiver **62.** The receive baseband modulated signal includes the transmit baseband modulated signal as well as the receive impairment spectrally separated from the transmit impairment.

The controller **21** includes a delay circuit **90** configured to delay the transmit baseband modulated signal so that this signal and the receive baseband modulated signal match up in time when compared. The delay circuit **90** may be configured to implement a fixed delay corresponding to inherent delays of the transmitters **22, 42** and the auxiliary receiver **62,** and a variable delay corresponding to variable environmental conditions. The variable delay accounts for environmental conditions, such as operating temperature variations, for example. In particular, the analog sections within the transmitter **22, 42** and the auxiliary receiver **62** are affected by temperature variations.

The impairment module **92** within the controller **21** estimates the IQ imbalance and other impairment within the selected transmitter **22, 42,** and generates an IQ or impairment compensation signal for that transmitter based on the estimated transmit impairment.

As stated above, the transmitters **22, 42** include transmit impairment compensators **27, 47** configured to compensate the transmit baseband modulated signal based on the compensation signal. The transmit impairment compensators **27, 47** are positioned between the data modulators **25, 45** and the mixers **28a, 28b, 48a, 48b.** Alternatively, the transmit impairment compensator **27** may be implemented within the controller itself if the transmitter chain is routed through the controller **21.**

The impairment module **92** is configured to estimate the transmit impairment by comparing the transmit baseband modulated signal with the receive baseband modulated signal while ignoring the receive impairment. The impairment module **92** performs the comparing in a plurality of iterations to determine difference values therebetween. The transmit impairment compensators **27, 47** then perform the compensation by iteratively adding correction values, as provided by the compensation signal, to the transmit baseband modulated signal to compensate for the difference values from the plurality of iterations. A least means square (LMS) algorithm may be used to determine the compensation values, for example.

Operation of the impairment module **92** may be simplified based on additional filtering of the receive baseband modulated signal before being provided as an input to the impairment module **92.** In the above embodiment, the controller **21** typically includes a filter **94** that should helpfully be large enough to pass the transmit impairment portion of the signal while rejecting the receive impairment portion of the signal. After the second down-conversion in the auxiliary receiver **21,** the transmit impairment signal centers at DC and can be isolated from the receiver impairments using a lowpass filter. This filter **94** isolates the transmit impairment signal so that the controller **21** can compare it to the ideal reference signal and estimate the impairments using the LMS algorithm or a different method.

In another embodiment of this filter **94,** a complex filter may be used. The complex filter is used to select the positive frequencies, which are then provided to the impairment module **94** after translating the positive frequencies at zero-IF.

As an alternative to the complex filter, a lossy integrator may filter the zero-IF down-converted signal in the auxiliary receiver **62.** This filter can be implemented very simply to have a cascade of filters, each with a single-pole IIR response. This filter implementation is inexpensive, yet very powerful. The filtering operation modifies the in-band frequency components of the auxiliary receiver output signal. Hence, it may be compared to a similarly modified reference signal (i.e., the ideal transmit signal from the data modulators **25, 45**). The same LMS update equations can be used to estimate the impairments caused in the transmitter.

The impairment module **94** may also be used to estimate and generate a receive impairment compensation signal to correct for impairments within the auxiliary receiver **62.** The auxiliary receiver **62** includes a receive impairment compensation signal for the receive impairment compensator or DSP block **64** within the auxiliary receiver **62.**

The receive impairment compensator **64** is at the output of the mixers **68a, 68b.** Alternatively, the receive impairment compensator **64** may be implemented within the controller itself if the receive chain is routed through the controller **21.** As discussed above for the estimation and compensation of the transmit impairment, an inverse system modeling is also used for the receive impairment

As discussed above, complex filtering and very selective complex lossy integrator filtering may be used to provide inputs to the impairment module **92.** In addition, the receive impairment may be estimated without requiring the transmit baseband modulated signal. Instead, a very selective complex lossy integrator may be used to extract a portion of the signal spectrum centered at the positive intermediate frequency, and a very selective complex lossy integrator may be used to extract a portion of the signal spectrum centered at the negative intermediate frequency.

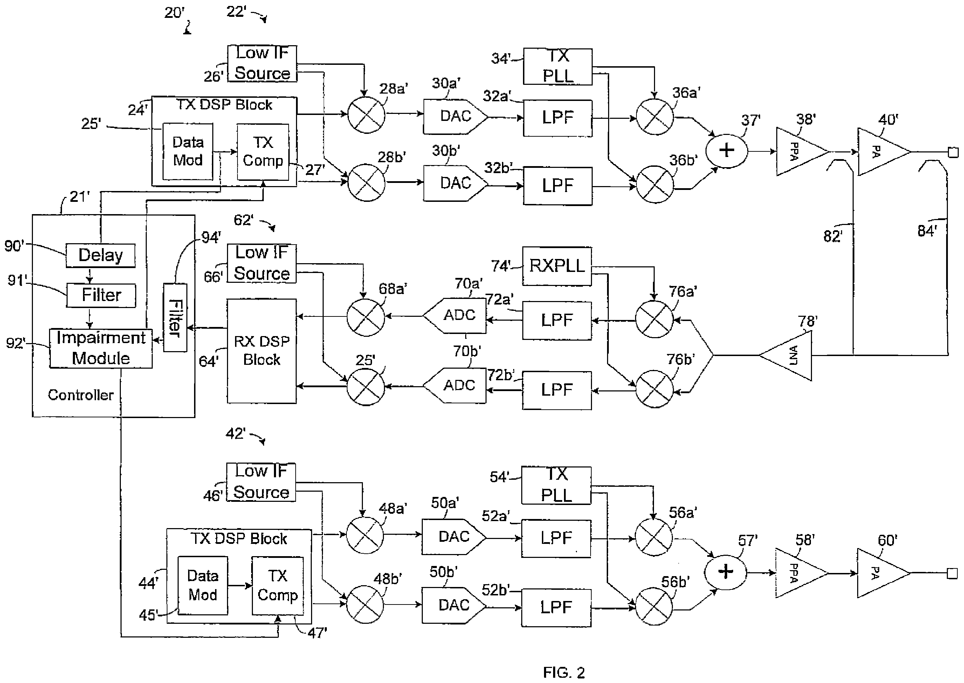

With reference to FIG. 2, an additional embodiment is now described. Here, the transmitters **22', 42'**, controller **21'**, and auxiliary receiver **62**' are similar to those described above, and are all integrated in a single integrated circuit. However, in this embodiment, there is no switching block, and the auxiliary receiver is coupled to the output of only one of the transmitters **22'**.

Since multiple transmitters implemented in a same integrated circuit are subject to approximately the same temperature, the performance of each transmitter is affected similarly due to heat. Therefore, in some applications, the impairment correction applied by the impairment module **92'** and TX compensator **27'** to correct the initial IQ imbalance in the transmitter **22',** can be applied to the second transmitter **42'** to obtain similar results. This reduces the cost of the communications device **20'** because less processing power may be used. As such, in this embodiment, the impairment correction applied by the impairment module **92'** and TX compensator **47'** to the transmitter **42'** is the same as, or based upon, the impairment correction applied to the transmitter **22'** (based upon the detected IQ imbalance in the transmit signal output by the transmitter **42'**).

Further details of the auxiliary receiver **62, 62'** may be found in co-pending application "WIRELESS COMMUNICATIONS DEVICE WITH IMPAIRMENT COMPENSATION AND ASSOCIATED METHODS," Attorney Docket Number 39393-US-PAT (85311), assigned to the same assignee as the present application.

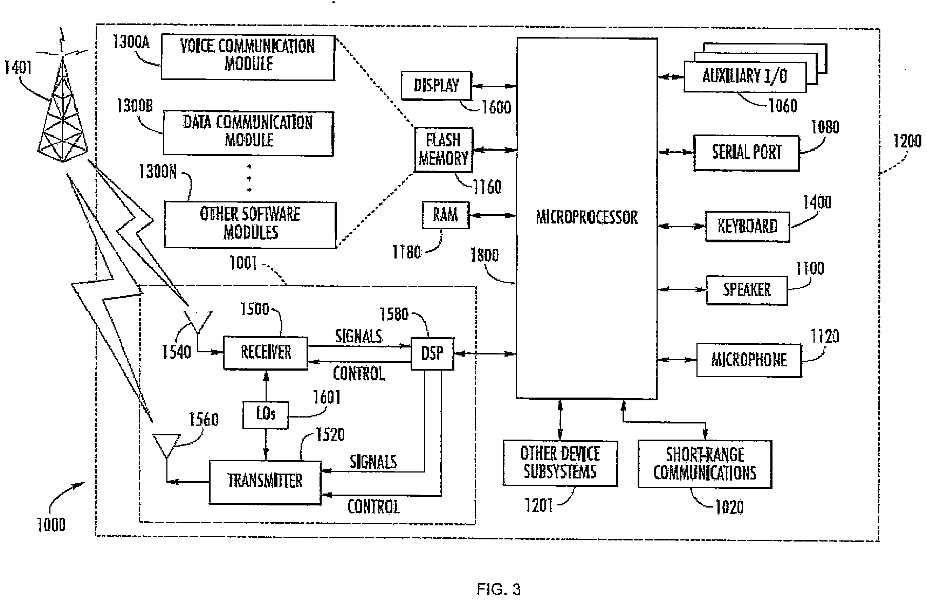

Example components of a hand-held mobile wireless communications device 1000 that may be used in accordance with the present disclosure are further described in the example below with reference to FIG. 3. The device 1000 illustratively includes a housing 1200, a keypad **1400** and an output device **1600.** The output device shown is a display **1600,** which may comprise a full graphic LCD. In some example embodiments, display **1600** may comprise a touch-sensitive input and output device. Other types of output devices may alternatively be utilized. A processing device **1800** is contained within the housing **1200** and is coupled between the keypad **1400** and the display **1600.** The processing device **1800** controls the operation of the display **1600,** as well as the overall operation of the mobile device **1000,** in response to actuation of keys on the keypad **1400** by the user. In some example embodiments, keypad **1400** may comprise a physical keypad or a virtual keypad (e.g., using a touch-sensitive interface) or both.

The housing **1200** may be elongated vertically, or may take on other sizes and shapes (including clamshell housing structures). The keypad **1400** may include a mode selection key, or other hardware or software for switching between text entry and telephony entry.

In addition to the processing device **1800,** other parts of the mobile device **1000** are shown schematically in FIG. 3. These include a communications subsystem **1001;** a short-range communications subsystem **1020;** the keypad **1400** and the display **1600,** along with other input/output devices **1060**, **1080, 1100** and **1120;** as well as memory devices **1160, 1180** and various other device subsystems **1201.** The mobile device **1000** may comprise a two-way RF communications device having voice and data communications capabilities. In addition, the mobile device **1000** may have the capability to communicate with other computer systems via the Internet.

Operating system software executed by the processing device **1800** may be stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM **1180.**

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM may be capable of organizing and managing data items, such as e-mail, calendar events, voice mails, appointments, and task items. The PIM application may also be capable of sending and receiving data items via a wireless network **1401.** The PIM data items may be seamlessly integrated, synchronized and updated via the wireless network **1401** with the device user's corresponding data items stored or associated with a host computer system.

Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex™, Data TAC™ or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device **1000.** The mobile device **1000** may also be compliant with other communications standards such as 3GSM, 3G, UMTS, 4G, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore utilizes a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem **1001** and is input to the processing device **1800.** The received signal is then further processed by the processing device **1800** for an output to the display **1600,** or alternatively to some other auxiliary I/O device **1060.** A device user may also compose data items, such as e-mail messages, using the keypad **1400** and/or some other auxiliary I/O device **1060,** such as a touchpad, a rocker switch, a thumb-wheel, track ball, or some other type of input device. The composed data items may then be transmitted over the communications network **1401** via the communications subsystem **1001.**

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device **1000.** In addition, the display **1600** may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, or a Bluetooth™ communications module to provide for communication with similarly-enabled systems and devices. Many modifications and other embodiments of the invention will come to the mind of one skilled in the art having the benefit of the teachings presented in the foregoing descriptions and the associated drawings.

## Claims

1. A communications device (20') comprising:
a plurality of wireless transmitters (22', 42') operating at different respective frequencies and each configured to generate respective IQ signals having an initial IQ imbalance;
an auxiliary receiver (62') coupled to a given wireless transmitter; and
a controller (21') coupled to the auxiliary receiver and configured to apply predistortion to each wireless transmitter of the plurality thereof based upon the initial IQ imbalance generated by the given wireless transmitter to reduce the initial IQ imbalance in each wireless transmitter.

2. The communications device (20') of Claim 1, wherein each wireless transmitter (22', 42') comprises a digital signal processing, DSP, block (24', 44') configured to receive an input baseband signal and to generate the IQ signal having the IQ imbalance; and wherein said controller (21') is configured to apply predistortion by generating and applying a predistortion signal to said DSP block (24', 44').

3. The communications device (20') of Claim 2, wherein each wireless transmitter further (22', 42') comprises at least one digital to analog converter, DAC, (30a'-30b', 50a'-50b') coupled downstream of said DSP block (24', 44').

4. The communications device (20') of Claim 3, wherein each wireless transmitter (22', 42') further comprises at least one mixer (36a'-36b', 56a', 56b') coupled downstream of said at least one DAC (30a'-30b', 50a'-50b').

5. The communications device (20') of Claim 4, wherein each wireless transmitter (22', 42') further comprises a phase locked loop, PLL, (34', 54') coupled to said at least one mixer (36a'-36b', 56a', 56b').

6. The communications device (20') of Claim 5, wherein each wireless transmitter (22', 42') further comprises at least one power amplifier (40', 60') downstream from said at least one mixer (36a'-36b', 56a', 56b').

7. The communications device (20') of Claim 1, wherein said auxiliary receiver (62') comprises a low noise amplifier, LNA, (78'), and at least one mixer (76a'-76b') coupled downstream of said LNA.

8. The communications device (20') of Claim 7, wherein said auxiliary receiver (62') further comprises a receiver phase locked loop, RXPLL, (74') coupled to said at least one mixer (76a'-76b').

9. The communications device (20') of Claim 8, wherein said auxiliary receiver (62') further comprises at least one analog to digital converter, ADC, (70a'-60b') coupled downstream of said at least one mixer (76a'-76b'), and a receiver DSP block (64') coupled to said at least one ADC (70a'-70b').

10. A method of operating a communications device (20') comprising a plurality of wireless transmitters (22', 42') operating at different respective frequencies and each configured to generate respective IQ signals having an initial IQ imbalance, an auxiliary receiver (62') coupled to a given wireless transmitter, and a controller (21') coupled to the auxiliary receiver, the method comprising:
applying predistortion to each wireless transmitter (22', 42') of the plurality thereof based upon the initial IQ imbalance generated by the given wireless transmitter to reduce the initial IQ imbalance in each wireless transmitter, using the controller (21').

11. The method of Claim 10, wherein each wireless transmitter (22', 42') comprises a digital signal processing, DSP, block (24', 44') configured to receive an input baseband signal and to generate the IQ signal having the IQ imbalance; wherein the controller (21') is configured to apply predistortion by generating and applying a predistortion signal to the DSP block; and wherein each wireless transmitter (22', 42') further comprises at least one digital to analog converter, DAC, (30a'-30b', 50a'-50b') coupled downstream of the DSP block (24', 44').

12. The method of Claim 11, wherein each wireless transmitter (22', 42') further comprises at least one mixer (36a'-36b', 56a'-56b') coupled downstream of the at least one DAC (30a'-30b', 50a'-50b'); wherein each wireless transmitter further (22', 42') comprises a phase locked loop, PLL, (34', 54') coupled to the at least one mixer (36a'-36b', 56a'-56b'); and wherein each wireless transmitter (22', 42') further comprises at least one power amplifier (40', 60') downstream from the at least one mixer (36a'-36b', 56a'-56b').

13. The method of Claim 10, wherein the auxiliary receiver (62') comprises a low noise amplifier, LNA, (78'), and at least one mixer (76a'-76b') coupled downstream of the LNA; and wherein the auxiliary receiver further comprises a receiver phase locked loop, RXPLL, (74') coupled to the at least one mixer.

14. The method of Claim 13, wherein the auxiliary receiver (62') further comprises at least one analog to digital converter, ADC, (70a'-70b') coupled downstream of the at least one mixer (76a'-76b'), and a receiver DSP block (64') coupled to the at least one ADC.

## Patentansprüche

1. Kommunikationsvorrichtung (20'), umfassend:
eine Vielzahl von drahtlosen Sendern (22', 42'), die mit unterschiedlichen jeweiligen Frequenzen arbeiten und jeweils dazu konfiguriert sind, jeweilige IQ-Signale mit einem anfänglichen Ungleichgewicht zu erzeugen;
einen Hilfsempfänger (62'), der mit einem bestimmtem drahtlosen Sender gekoppelt ist; und
eine Steuerung (21'), die mit dem Hilfsempfänger gekoppelt und dazu konfiguriert ist, basierend auf dem durch den bestimmten drahtlosen Sender erzeugten anfänglichen IQ-Ungleichgewicht eine Vorverzerrung an jeden drahtlosen Sender der Vielzahl von diesen anzulegen, um das anfängliche IQ-Ungleichgewicht in jedem drahtlosen Sender zu reduzieren.

2. Kommunikationsvorrichtung (20') nach Anspruch 1, wobei jeder drahtlose Sender (22', 42') einen digitalen Signalverarbeitungsblock (DSP-Block) (24', 44') umfasst, der dazu konfiguriert ist, ein Eingangsbasisbandsignal zu empfangen und das IQ-Signal mit dem IQ-Ungleichgewicht zu erzeugen; und wobei die Steuerung (21') dazu konfiguriert ist, durch Erzeugen und Anlegen eines Vorverzerrungssignals an den DSP-Block (24', 44'), eine Vorverzerrung anzulegen.

3. Kommunikationsvorrichtung (20') nach Anspruch 2, wobei jeder drahtlose Sender (22', 42') ferner mindestens einen dem DSP-Block (24', 44') nachgeschaltet einkoppelten Digital-Analog-Wandler (DAW) (30a'-30b', 50a'-50b') umfasst.

4. Kommunikationsvorrichtung (20') nach Anspruch 3, wobei jeder drahtlose Sender (22', 42') ferner mindestens einen Mischer (36a'-36b', 56a', 56b') umfasst, der dem mindestens einen DAW (30a'-30b', 50a'-50b') nachgeschaltet eingekoppelt ist.

5. Kommunikationsvorrichtung (20') nach Anspruch 4, wobei jeder drahtlose Sender (22', 42') ferner eine Phasenregelschleife (PLL) (34', 54') umfasst, die mit dem mindestens einen Mischer gekoppelt (36a'-36b', 56a', 56b') ist.

6. Kommunikationsvorrichtung (20') nach Anspruch 5, wobei jeder drahtlose Sender (22', 42') ferner mindestens einen Leistungsverstärker (40', 60') umfasst, der dem mindestens einen Mischer (36a'-36b', 56a', 56b') nachgeschaltet ist.

7. Kommunikationsvorrichtung (20') nach Anspruch 1, wobei der Hilfsempfänger (62') einen rauscharmen Verstärker (LNA) (78') und mindestens einen dem LNA nachgeschaltet eingekoppelten Mischer (76a'-76b') umfasst.

8. Kommunikationsvorrichtung (20') nach Anspruch 7, wobei der Hilfsempfänger (62') ferner eine Empfänger-Phasenregelschleife (RXPLL) (74') umfasst, die mit dem mindestens einen Mischer (76a'-76b') gekoppelt ist.

9. Kommunikationsvorrichtung (20') nach Anspruch 8, wobei der Hilfsempfänger (62') ferner mindestens einen Analog-Digital-Wandler (ADW) (70a'-60b'), der dem mindestens einen Mischer (76a'-76b') nachgeschaltet eingekoppelt ist, und einen mit dem mindestens einen ADW (70a'-70b') gekoppelten Empfänger-DSP-Block (64') umfasst.

10. Verfahren zum Betreiben einer Kommunikationsvorrichtung (20'), die eine Vielzahl von drahtlosen Sendern (22', 42'), die mit unterschiedlichen jeweiligen Frequenzen arbeiten und jeweils dazu konfiguriert sind, jeweilige IQ-Signale mit einem anfänglichen Ungleichgewicht zu erzeugen, einen Hilfsempfänger (62'), der mit einem bestimmtem drahtlosen Sender gekoppelt ist, und eine Steuerung (21'), die mit dem Hilfsempfänger gekoppelt ist, umfasst, wobei das Verfahren umfasst:
Anlegen, unter Verwendung der Steuerung (21') und basierend auf dem durch den bestimmten drahtlosen Sender erzeugten anfänglichen IQ-Ungleichgewicht, einer Vorverzerrung an jeden drahtlosen Sender (22', 42') der Vielzahl von diesen, um das anfängliche IQ-Ungleichgewicht in jedem drahtlosen Sender zu reduzieren.

11. Verfahren nach Anspruch 10, wobei jeder drahtlose Sender (22', 42') einen digitalen Signalverarbeitungsblock (DSP-Block), (24', 44') umfasst, der dazu konfiguriert ist, ein Eingangsbasisbandsignal zu empfangen und das IQ-Signal mit dem IQ-Ungleichgewicht zu erzeugen; wobei die Steuerung (21') dazu konfiguriert ist, durch Erzeugen und Anlegen eines Vorverzerrungssignals an den DSP-Block (24', 44') eine Vorverzerrung anzulegen; und wobei jeder drahtlose Sender (22', 42') ferner mindestens einen dem DSP-Block (24', 44') nachgeschaltet einkoppelten Digital-Analog-Wandler (DAW) (30a'-30b', 50a'-50b') umfasst.

12. Verfahren nach Anspruch 11, wobei jeder drahtlose Sender (22', 42') ferner mindestens einen Mischer (36a'-36b', 56a', 56b') umfasst, der dem mindestens einen DAW (30a'-30b', 50a'-50b') nachgeschaltet eingekoppelt ist; wobei jeder drahtlose Sender (22', 42') ferner eine Phasenregelschleife (PLL) (34', 54') umfasst, die mit dem mindestens einen Mischer gekoppelt (36a'-36b', 56a', 56b') ist; und wobei jeder drahtlose Sender (22', 42') ferner mindestens einen Leistungsverstärker (40', 60') umfasst, der dem mindestens einen Mischer (36a'-36b', 56a', 56b') nachgeschaltet ist.

13. Verfahren nach Anspruch 10, wobei der Hilfsempfänger (62') einen rauscharmen Verstärker (LNA) (78') und mindestens einen dem LNA nachgeschaltet eingekoppelten Mischer (76a'-76b') umfasst; und wobei der Hilfsempfänger ferner eine Empfänger-Phasenregelschleife (RXPLL) (74') umfasst, die mit dem mindestens einen Mischer (76a'-76b') gekoppelt ist.

14. Verfahren nach Anspruch 13, wobei der Hilfsempfänger (62') ferner mindestens einen Analog-Digital-Wandler (ADW) (70a'-60b'), der dem mindestens einen Mischer (76a'-76b') nachgeschaltet eingekoppelt ist, und einen mit dem mindestens einen ADW (70a'-70b') gekoppelten Empfänger-DSP-Block (64') umfasst.

## Revendications

1. Dispositif de communication (20') comprenant :
une pluralité d'émetteurs-récepteurs sans fil (22', 42') fonctionnant sur des fréquences respectives différentes, chacun étant configuré pour produire des signaux IQ respectifs possédant un déséquilibre IQ initial ;
un récepteur auxiliaire (62') couplé à un émetteur-récepteur sans fil donné ; et
un contrôleur (21') couplé au récepteur auxiliaire et configuré pour appliquer une prédistorsion à chaque émetteur-récepteur sans fil de la pluralité, en fonction du déséquilibre IQ initial produit par l'émetteur-récepteur sans fil donné, afin de réduire le déséquilibre IQ initial sur chaque émetteur-récepteur sans fil.

2. Dispositif de communication (20') selon la revendication 1, dans lequel chaque émetteur-récepteur sans fil (22', 42') comprend un bloc de traitement numérique du signal, DSP, (24, 44') configuré pour recevoir un signal d'entrée en bande de base et pour produire le signal IQ présentant le déséquilibre IQ ; et dans lequel ledit contrôleur (21') est configuré pour appliquer une prédistorsion en produisant et en appliquant un signal de prédistorsion audit bloc DSP (24, 44').

3. Dispositif de communication (20') selon la revendication 2, dans lequel chaque émetteur-récepteur sans fil (22', 42') comprend en outre au moins un convertisseur numérique-analogique, CNA, (30a' à 30b', 50a' à 50b') couplé en aval dudit bloc DSP (24, 44').

4. Dispositif de communication (20') selon la revendication 3, dans lequel chaque émetteur-récepteur sans fil (22', 42') comprend en outre au moins un mélangeur (36a' à 36b', 56a', 56b') couplé en aval dudit au moins un CNA (30a' à 30b', 50a' à 50b').

5. Dispositif de communication (20') selon la revendication 4, dans lequel chaque émetteur-récepteur sans fil (22', 42') comprend en outre une boucle verrouillée en phase, PLL, (34', 54') couplée audit au moins un mélangeur (36a' à 36b', 56a', 56b').

6. Dispositif de communication (20') selon la revendication 5, dans lequel chaque émetteur-récepteur sans fil (22', 42') comprend en outre au moins un amplificateur de puissance (40', 60') couplé en aval dudit au moins un mélangeur (36a' à 36b', 56a', 56b').

7. Dispositif de communication (20') selon la revendication 1, dans lequel ledit récepteur auxiliaire (62') comprend un amplificateur à faible bruit, LNA, (78') et au moins un mélangeur (76a' à 76b') couplé en aval dudit LNA.

8. Dispositif de communication (20') selon la revendication 7, dans lequel ledit récepteur auxiliaire (62') comprend en outre une boucle verrouillée en phase de récepteur, RXPLL, (74') couplée audit au moins un mélangeur (76a' à 76b').

9. Dispositif de communication (20') selon la revendication 8, dans lequel ledit récepteur auxiliaire (62') comprend en outre au moins un convertisseur analogique-numérique, CAN, (70a' à 70b') couplé en aval dudit au moins un mélangeur (76a' à 76b'), et un bloc DSP de récepteur (64') couplé audit au moins un CAN (70a' à 70b').

10. Procédé de fonctionnement d'un dispositif de communication (20') comprenant une pluralité d'émetteurs-récepteurs sans fil (22', 42') fonctionnant sur des fréquences respectives différentes, chacun étant configuré pour produire des signaux IQ respectifs possédant un déséquilibre IQ initial, un récepteur auxiliaire (62') couplé à un émetteur-récepteur sans fil donné, et un contrôleur (21') couplé au récepteur auxiliaire, le procédé consistant à :
appliquer une prédistorsion à chaque émetteur-récepteur sans fil de la pluralité, en fonction du déséquilibre IQ initial produit par l'émetteur-récepteur sans fil donné, afin de réduire le déséquilibre IQ initial sur chaque émetteur-récepteur sans fil, en utilisant le contrôleur (21').

11. Procédé selon la revendication 10, dans lequel chaque émetteur-récepteur sans fil (22', 42') comprend un bloc de traitement numérique du signal, DSP, (24, 44') configuré pour recevoir un signal d'entrée en bande de base et pour produire le signal IQ présentant le déséquilibre IQ ; dans lequel le contrôleur (21') est configuré pour appliquer une prédistorsion en produisant et en appliquant un signal de prédistorsion audit bloc DSP ; et dans lequel chaque émetteur-récepteur sans fil (22', 42') comprend en outre au moins un convertisseur numérique-analogique, CNA, (30a' à 30b', 50a' à 50b') couplé en aval du bloc DSP (24, 44').

12. Procédé selon la revendication 11, dans lequel chaque émetteur-récepteur sans fil (22', 42') comprend en outre au moins un mélangeur (36a' à 36b', 56a' à 56b') couplé en aval dudit au moins un CNA (30a' à 30b' , 50a' à 50b') ; dans lequel chaque émetteur-récepteur sans fil (22', 42') comprend en outre une boucle verrouillée en phase, PLL, (34', 54') couplée audit au moins un mélangeur (36a' à 36b', 56a' à 56b') ; et dans lequel chaque émetteur-récepteur sans fil (22', 42') comprend en outre au moins un amplificateur de puissance (40', 60') couplé en aval dudit au moins un mélangeur (36a' à 36b', 56a'à 56b').

13. Procédé selon la revendication 10, dans lequel le récepteur auxiliaire (62') comprend un amplificateur à faible bruit, LNA, (78') et au moins un mélangeur (76a' à 76b') couplé en aval dudit LNA ; et dans lequel le récepteur auxiliaire (62') comprend en outre une boucle verrouillée en phase de récepteur, RXPLL, (74') couplée audit au moins un mélangeur.

14. Procédé selon la revendication 13, dans lequel le récepteur auxiliaire (62') comprend en outre au moins un convertisseur analogique-numérique, CAN, (70a' à 70b') couplé en aval dudit au moins un mélangeur (76a' à 76b'), et un bloc DSP de récepteur (64') couplé audit au moins un CAN.
